# EUROPEAN PATENT SPECIFICATION

(11) **EP 0 552 963 B1**
(45) Date of publication and mention of the grant of the patent: **08.10.1997**
(21) Application number: 93300446.7
(22) Date of filing: 21.01.1993
(51) Int. Cl.: H03K 19/0944

(54) **Noninverting logic gate**
Nichtinvertierendes logisches Tor
Porte logique non-inverseuse

(30) Priority: 22.01.1992 US 824630
(43) Date of publication of application: 28.07.1993
(73) Proprietor: SAMSUNG SEMICONDUCTOR, INC., San Jose, California 95134-1708 (US)
(72) Inventor: Khieu, Cong, San Jose, California 95133 (US)
(74) Representative: Jones, Ian

(56) References cited:
- EP-A- 0 488 328
- US-A- 5 057 713
- IBM TECHNICAL DISCLOSURE BULLETIN. vol. 34, no. 2, 2 July 1991, NEW YORK US pages 433 - 435 'bicmos selector'
- JP-A 03 250 664 in: Patent Abstracts of Japan

## Description

This invention relates to noninverting logic gates, such as buffers.

A multitude of digital design applications involve placing a noninverting buffer element in a signal path. Conventional noninverting buffer elements in Bi-CMOS technology, however, actually comprise two Bi-CMOS inverters connected in series. The output of a first Bi-CMOS inverter is linked to the input of the second Bi-CMOS inverter. The output of this second Bi-CMOS inverter is the output of the buffer. Such conventional Bi-CMOS buffers, therefore, introduce roughly twice the propagation delay into the signal path than a single Bi-CMOS inverter does.

This large propagation delay of Bi-CMOS buffers is highly undesirable in many applications. In a Bi-CMOS static RAM, for example, the access time between the time when the address appears at the address input pins and the time when the static RAM actually outputs the data is critical. Great expense is directed to reducing this propagation delay.

Inside a static RAM, an address decoder decodes the address onto a series of decoder output lines. Each of the output lines is associated with a memory block. Accordingly, when an address is decoded, one of the output lines is activated. Activation of this output line indicates the memory block to which the address is mapped. Due to the architecture of the decoder, however, both the active high and active low versions of each address input line is required as an input into the decoder.

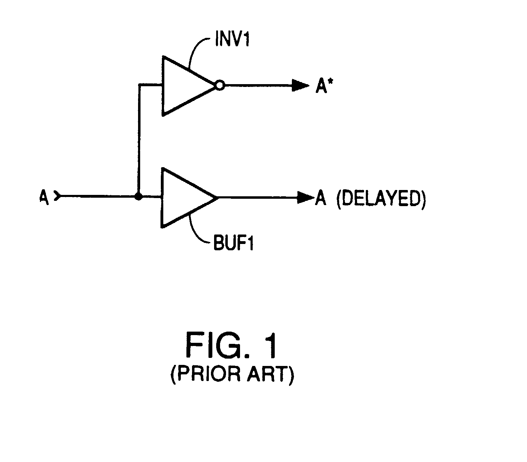

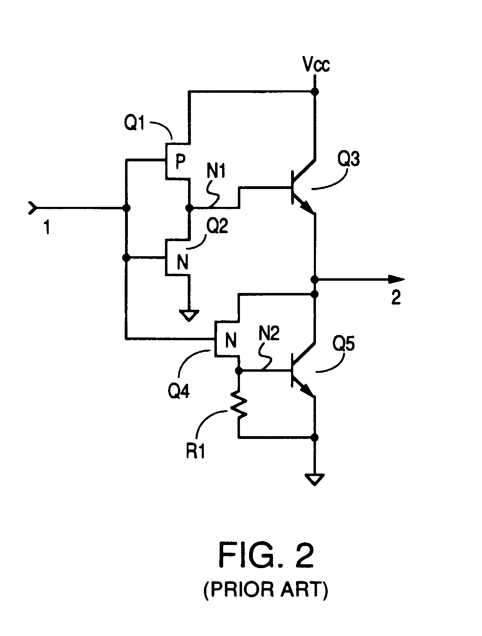

Reference is now made to the accompanying drawings, in which Figure 1 is an application in which a Bi-CMOS noninverting buffer with a propagation delay of a single Bi-CMOS inverter is desirable and Figure 2 is a diagram of a conventional Bi-CMOS inverter.

Figure 1 (PRIOR ART) shows address input line signal A passing through inverter INV1 so that inverted signal A∗ is produced. This output is delayed with respect to the address input line signal A by the inverter propagation delay of INV1. Noninverting buffer BUF1 is provided to produce signal A(delayed). Because buffer BUF1 really comprises two inverters, signal A(delayed) is delayed with respect to the address input line signal A by two inverter delays. Therefore, the A(delayed) signal is delayed with respect to the signal A∗ by one inverter delay. If no buffer were provided, one inverter delay would still exist between signal A∗ and signal A.

Due to the multiple problems confronting digital designers including the above described time skew problem, it would be desirable to have a Bi-CMOS buffer circuit as well as other noninverting logic gates which have the same delay as a single Bi-CMOS inverter. The speed of the slowest path through the decoder could be increased. Furthermore, because the skew between signals A∗ and A(delayed) would be reduced, the inputs to the decoder could be readily altered in the event that the decoding logic should be changed.

Figure 2 (PRIOR ART) is a circuit diagram of a conventional Bi-CMOS inverter. When the voltage on the input 1 to the inverter transitions from a high digital logic voltage to a low digital logic voltage, P channel transistor Q1 turns on and N channel transistor Q2 turns off. As a result, node N1 is driven high, the voltage on the base of bipolar output transistor Q3 increases, and bipolar transistor Q3 turns on. When the voltage on input 1 transition from high to low, N channel transistor Q4 is also turned off. As a result node N2 is pulled low through resistance R1 thereby turning bipolar output transistor Q5 off. With bipolar output transistor Q3 being on and bipolar output transistor Q5 being off, the output 2 of the Bi-CMOS inverter transitions from low to high.

In the case of input 1 transitioning high, node N1 goes low to turn bipolar transistor Q3 off. Transistor Q4 is also turned on. Charge stored in the base of transistor Q5 will pass through transistor Q4, to the collector of now saturated transistor Q5, through transistor Q5 and to ground. The voltage on the base of bipolar transistor Q5 therefore increases and bipolar transistor Q5 is turned on. Because bipolar transistor Q5 is on and bipolar transistor Q3 is off, the voltage on the output 2 of the conventional Bi-CMOS inverter transitions from high to low.

JP-A-03250664, EP-A-0488328 and IBM Technical Disclosure Bulletin vol 34, No 2, July 1991, New York, US, pages 433-435 "Bi-CMOS selector" all disclose other known buffers for Bi-CMOS semiconductor integrated circuits.

According to the present invention there is provided a digital logic circuit having an input and an output and comprising: an inverter having an input coupled to the input of the digital logic circuit, and an output; a first passgate having a data input, a data output, a first control input coupled to the output of the inverter, and a second control input coupled to the input of the digital logic circuit; a second passgate having a data input, a data output coupled to the data output of the first passgate, a first control input coupled to the second control input of the first passgate, and a second control input coupled to the first control input of the first passgate; and a first bipolar transistor having a first terminal coupled to the data input of the second passgate and to a first power supply voltage, a second terminal coupled to the output of the digital logic circuit, and a control terminal coupled to the data output of the first passgate; and being characterised by: a second bipolar transistor having a first terminal coupled to the output of the digital logic circuit, a second terminal coupled to the data input of the first passgate and to a second power supply voltage, and a control terminal; and a P channel transistor having a first terminal coupled to the output of the digital logic circuit, a second terminal coupled to the control terminal of the second bipolar transistor, and a control terminal coupled to the input of the digital logic circuit.

Thus, in a noninverting Bi-CMOS gate of the present invention, one or more passgates are utilized in the control path leading to a bipolar output transistor. This bipolar output transistor switches the output of the Bi-CMoS gate. The control gate of one of the CMOS transistors of each passgate is connected to an input signal. The control gate of the other CMOS transistor of each passgate is connected to the complement of the input signal. Because the input signal is directly connected to the control gate of one of the CMOS transistors of the passgate, one transistor of the passgate begins switching immediately upon the transition of the input signal. This allows the output of the passgate to begin changing the voltage on the base of the bipolar output transistor immediately after the MOS transistor connected to the input signal switches.

The other CMOS transistor of the passgate is controlled by the complement of the input signal. Accordingly, the complement arrives at the gate of the other MOS transistor of the passage after an inverter propagation delay. After this delay, the complement signal switches the other MOS transistor in the passgate, thereby causing each passgate to be turned either completely on or off. When the passgate turns completely on or off, the voltage on the base of the bipolar output transistor completes its voltage transition to switch the bipolar output transistor.

This technique utilizing passages is employed to create a family of Bi-CMOS noninverting gates such as buffers, AND gates and complex gates, the propagation of the family being roughly equal to the propagation delay of a single Bi-CMOS inverter. Members of this new family of Bi-CMOS gates can be cascaded with each other and can also drive other Bi-CMOS gates.

The invention is further described below, by way of example, with reference to the remaining figures of the accompanying drawings, in which:
Figure 3 is a diagram of a noninverting Bi-CMOS buffer according to the present invention; and
Figure 4 is a diagram of a Bi-CMOS AND gate which is not claimed.

In the following discussion, the operation of the present invention is described by denoting certain nodes transitioning high or low or having certain voltages. It is to be understood, however, that this terminology is used only to simplify the explanation for the reader and that the bipolar transistors in the invention are actually standard bipolar transistors whose operation is well characterised by base, collector and emitter currents as well as terminal voltages.

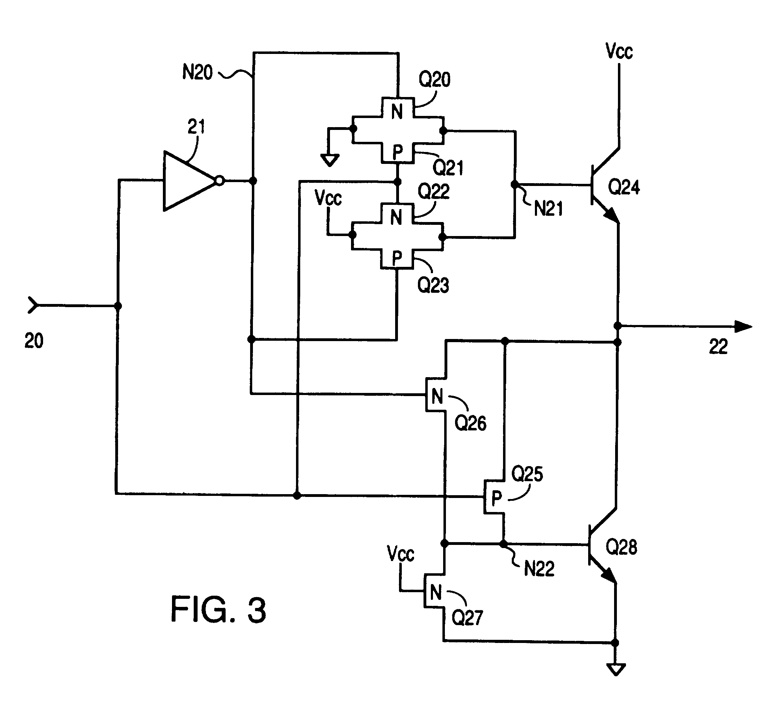

Figure 3 is a diagram of a noninverting Bi-CMOS buffer according to the present invention. An inverter 21 is connected to the input of the buffer 20 to drive node N20 with the complement of the input signal on input 20. Accordingly, the input signal is available for use by the buffer circuitry as well and the complement of the input signal. The input signal and its complement are then connected to two passgates. The first passgate, comprised of N channel transistor Q20 and P channel transistor Q21, is connected between ground and a passgate output node N21. The second passgate, comprised of N channel transistor Q22 and P channel transistor Q23, is connected between Vcc and the passgate output node N21.

The N channel transistor Q20 of the first passgate and the P channel transistor Q23 of the second passgate are connected to the complement of the input signal on node N20. Due to this connection, only one of these two transistors is on at a time. The particular transistor that is on depends on whether node N20 is high or low.

Similarly, the N channel transistor Q22 of the second passgate and the P channel transistor Q21 of the first passgate are connected to the input signal itself on input 20. This way only one of these two transistors is on at a time. The particular transistor that is on depends on whether the input signal is high or low.

Passgate output node N21 is connected to the base of a first NPN bipolar transistor Q24. The collector of transistor Q24 is connected to Vcc and the emitter of transistor Q24 is connected to buffer output 22. Accordingly, a high voltage on node N21 will turn bipolar transistor Q24 on and a low voltage will turn bipolar transistor Q24 off.

A second NPN bipolar transistor Q28 is connected between the buffer output 22 and ground. The collector of transistor Q28 is connected to buffer output 22 and the emitter of transistor Q28 is connected to ground. The voltage on a node N22 which is connected to the base of transistor Q28 determines whether transistor Q28 is on or off.

A P channel transistor Q25 is connected between the buffer output 22 and node N22. The gate of this transistor Q25 is connected to the buffer input 20. An N channel transistor Q27 is connected between node N22 and ground to serve as a resistance to ground. The gate of transistor Q27 is therefore tied to Vcc.

Another transistor, N channel transistor Q26, is connected between buffer output 22 and node N22. The gate of this transistor Q26 is connected to node N20 to be connected to the complement of the buffer input signal.

Operation of the buffer is explained in two time periods. When the input 20 transitions low, for example, a first time period begins. The gate of P channel transistor Q21 of the first passgate is forced low due to its direct connection with input 20. Transistor Q21 is, therefore, turned on before the low transitioning input signal has been inverted by inverter 21. Simultaneously, N channel transistor Q22 of the second passgate is turned off. Accordingly, because the voltage on node N20 will still be low when the voltage on input 20 first begins going low, transistor Q23 will still be on. As a result, transistors Q21 and Q23 are both on to form a voltage divider between Vcc and ground. Node N21 is therefore driven with a voltage somewhat below Vcc. The base of bipolar transistor Q24 therefore begins to fall after only one transistor delay through transistors Q21 and Q22. When the base of bipolar transistor Q24 falls, bipolar transistor Q24 begins to turn off.

The speed of the voltage drop on node N21 is adequate to initiate the switching off transistor Q24 because the voltage on the buffer output 22 was initially at approximately Vcc - .7 volts. Node N21 therefore only need be dropped slightly below Vcc to begin switching transistor Q24 off.

Also, during the first time period, the gate of P channel transistor Q25 is driven low due to the direct connection of the gate of the transistor Q25 to input 20. As a result, transistor Q25 turns on. Because the voltage on node N20 is still low when input 20 first begins transitioning low, transistor Q26 remains off. As a result, resistive transistor Q27, nonconducting transistor Q26, and conducting transistor Q25 form a voltage divider between buffer output 22 and ground. The voltage on node N22 therefore increases from ground to the voltage output by the voltage divider network. As a result, bipolar transistor Q28 starts to turn on.

In one embodiment, the effective on resistance of transistor Q27 is approximately 20 kΩ and the effective on resistance of transistor Q26 is approximately 0.5 kΩ. Transistor Q27 is therefore used to discharge the base of transistor Q28 to prevent it from floating high when transistors Q26 and Q25 are off. The discharging of the base of transistor Q28 can be accomplished with a small current and a transistor Q27 can have an approximate width to length ratio of W/L = 2/5.

Then, at the beginning of the second time period, inverter 21 finally outputs a high voltage level on node N20. When node N20 goes high, transistor Q20 of the first passgate is turned on. Transistors Q20 and Q21 of the first passgate are therefore both on. Similarly, node N20 going high turns transistor Q23 off. Transistors Q22 and Q23 of the second passgate are therefore both off. As a result, the voltage divider through transistors Q21 and Q23 is destroyed, node N21 is connected to ground through the first passgate, the voltage on node N21 decreases further toward ground, and bipolar transistor Q24 is turned completely off.

Also in the beginning of the second time period, the gate of N channel transistor Q26 is driven high. As a result, transistor Q26 is turned on. Because transistor Q25 was already turned on in the first time period, both transistors Q26 and Q25 function to pull node N22 higher against the load of resistive transistor Q27. Bipolar transistor Q28 is therefore turned on even more strongly that it was in the first period.

One function of transistor Q26 is to prevent charge from becoming trapped on node N22 due to transistor Q25 being a P-channel transistor rather than a N channel transistor. If the resistance of transistor Q27 is adequately low, if the switching frequency of the input signal on input 20 is adequately high, and if transistor Q25 is a P-channel transistor, the base of transistor Q28 may not be discharged to the collector of transistor Q28 when input 20 transitions low. In this situation, the P-channel transistor Q25 will only pull the voltage on node N22 to a voltage of one threshold voltage V_{T} below the voltage on output 22. If Q28 is in deep saturation, the voltage on the collector of transistor Q28 may be as low as approximately 0.2 volts. The base of transistor Q28 will therefore not be discharged through a P channel transistor. If, on the other hand, an extra N channel transistor Q26 is included, charge from the base of a saturated transistor Q28 will pass to the collector of transistor Q28 and the voltage on node N22 will increase due to the series base resistance r_{b} of transistor Q28. A saturated transistor Q28 will therefore be pulled out of saturation. If transistor Q28 going into saturation is not a problem, the N channel transistor Q26 need not be incorporated.

Whether or not a transistor Q26 is provided, the output of the Bi-CMOS buffer circuit begins to transition after the switching delay through a single MOS transistor plus the propagation delay of an output bipolar transistor Q24 or Q28. This total propagation delay through the Bi-CMOS buffer is roughly the same as the propagation delay through the conventional Bi-CMOS inverter of Figure 2. The output of the conventional Bi-CMOS inverter of Figure 2 begins to switch after the switching delay through one MOS transistor plus the propagation delay of an output bipolar transistor Q3 or Q5.

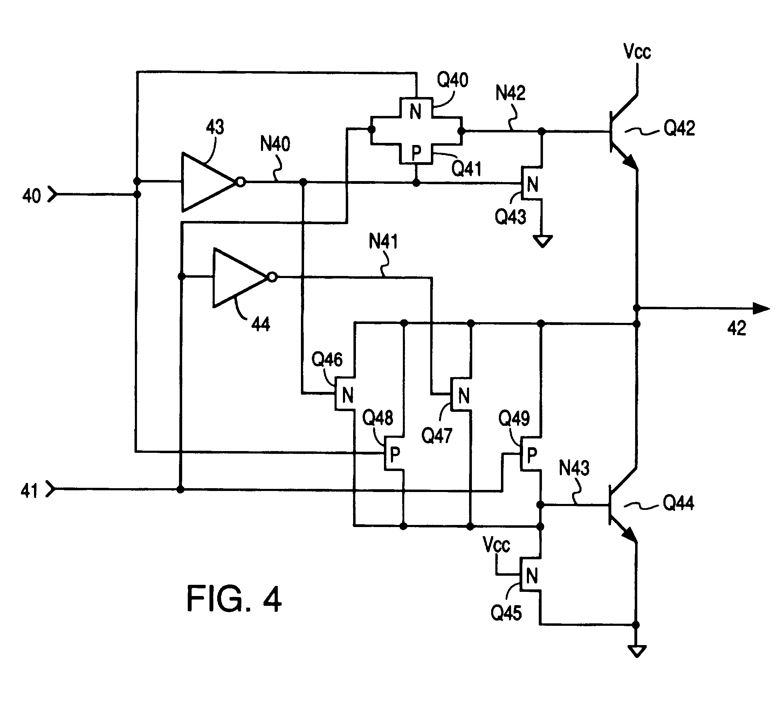

Figure 4 is a circuit diagram of an AND gate. This AND gate is but one example of a gate according to the present invention. This AND gate has a first input 40, a second input 41, and one output 42. The first input 40 is connected to the input of a first inverter 43. The second input 41 is connected to the input of a second inverter 44. Inverter 43 generates the complement of the signal on first input 40. This complement is output by inverter 43 onto node N40. Similarly, inverter 44 outputs the complement of the signal on second input 41 onto node N41.

A passgate formed by N channel MOS transistor Q40 and P channel MOS transistor Q41 is connected between second input 41 and a passgate output node N42. The gate of P channel transistor Q41 is connected to node N40. The gate of the N channel transistor Q40 is connected to the first input 40. The passgate output node N42 is connected to the base of a first NPN bipolar output transistor Q42. The collector of bipolar transistor Q42 is connected to the AND gate output 42. An N channel transistor Q43 is connected between node N42 and ground. The gate of transistor Q43 is connected to node N40.

A second NPN bipolar output transistor Q44 is also provided. The collector of transistor Q44 is connected to the AND gate output 42. The emitter of the transistor Q44 is connected to ground. The base of bipolar transistor Q44 is connected to node N43.

Two N channel transistors Q46 and Q47 are connected between the AND gate output 42 and node N43. Two P channel transistors Q48 and Q49 are connected between AND gate output 42 and node N43. The gate of transistor Q46 is connected to node N40; the gate of transistor Q48 is connected to first input 40; the gate of transistor Q47 is connected to node N41; and the gate of transistor Q49 is connected to second input 41. Another N channel transistor Q45 is connected between node N43 and ground. The gate of transistor Q45 is tied to Vcc.

In operation, if first input 40 and second input 41 are both high, the output 42 will be driven high. If input 40 is high, transistor Q40 is turned on. Transistor Q41 is turned on due to the low voltage placed on node N40 by inverter 43. Transistor Q43 is an N channel transistor and therefore is off when node N40 is low. Because input 41 is high, a high signal passes through the passgate formed by transistors Q40 and Q41 and passes onto the base of bipolar transistor Q42 at node N42. Bipolar transistor Q42 is therefor turned on.

Because input 40 is directly connected to P channel transistor Q48 and because input 41 is directly connected to P channel transistor Q49, both transistors Q48 and Q49 are off. Similarly, because N channel transistors Q46 and Q47 are driven by inverters 43 and 44, nodes N40 and N41 are both low and transistors Q46 and Q47 are off. As a result, the voltage on node 43 is pulled to ground by resistive transistor Q45 so that the base of bipolar transistor Q44 is held. Transistor Q44 is therefore off. With bipolar transistor Q42 being on and bipolar transistor Q44 being off, the voltage on output 42 is high.

In the condition that either input 40 or input 41 is low, either node N40 or node N41 will be driven high by an inverter and one of N channel transistors Q46 or Q47 will be on. Additionally, if either input 40 or input 41 is low, one of P channel transistors Q48 and Q49 will be turned on due to their direct connections with the inputs. As a consequence, the base of bipolar transistor Q44 will be coupled to the collector of transistor Q44.

Furthermore, if input 40 is low, the passgate formed by N channel transistor Q40 and P channel transistor Q41 will be turned off. Node N42 will be pulled to ground by N channel transistor Q43 because the gate of N channel transistor Q43 is connected to node N40 which is driven with a high signal by inverter 43. If, on the other hand, input 40 is high but input 41 is low, the passgate formed by transistors Q40 and Q41 will be on to pass the low voltage on input 41 onto node N42 and the base of bipolar transistor Q42. It is therefore seen that if either input 40 or input 41 is low, bipolar transistor Q42 is off and bipolar transistor Q44 is on. The voltage on output 42 therefore is low when either or both of inputs 40 and 41 is low. Accordingly, the circuit of Figure 4 performs an AND function. N channel transistors Q46 and Q47 of Figure 4 are added to ensure that the voltage on the base of bipolar transistor Q44 can be increased in the condition transistor Q44 is in deep saturation. In some embodiments, transistors Q46 and Q47 are not necessary and are therefore need not be included.

Although specific embodiments of the present invention are described in the foregoing disclosure, it is evident that multiple adaptations to other semiconductor technologies as well as other logic gates will become apparent to those skilled in the art. Accordingly, this description is to be construed as illustrative only and is for the purpose of teaching one manner of carrying out the invention. Specifics of the embodiments described above are therefore not intended to limit the scope of the invention as set forth in the appended claims.

## Claims

1. A digital logic circuit having an input and an output and comprising:
an inverter having an input coupled to the input of the digital logic circuit, and an output;
a first passgate having a data input, a data output, a first control input coupled to the output of the inverter, and a second control input coupled to the input of the digital logic circuit;
a second passgate having a data input, a data output coupled to the data output of the first passgate, a first control input coupled to the second control input of the first passgate, and a second control input coupled to the first control input of the first passgate; and
a first bipolar transistor having a first terminal coupled to the data input of the second passgate and to a first power supply voltage, a second terminal coupled to the output of the digital logic circuit, and a control terminal coupled to the data output of the first passgate; and being characterised by:
a second bipolar transistor having a first terminal coupled to the output of the digital logic circuit, a second terminal coupled to the data input of the first passgate and to a second power supply voltage, and a control terminal; and
a P channel transistor having a first terminal coupled to the output of the digital logic circuit, a second terminal coupled to the control terminal of the second bipolar transistor, and control terminal coupled to the input of the digital logic circuit.

2. A circuit as claimed in claim 1, comprising an N channel transistor having a first terminal coupled to the output of the digital logic circuit, a second terminal coupled to the control terminal of the second bipolar transistor, and a control terminal coupled to the output of the inverter.

3. A circuit as claimed in claim 1, wherein the first passgate comprises a P channel transistor and an N channel transistor, wherein the second passgate comprises a P channel transistor and an N channel transistor, wherein a gate electrode of the P channel transistor of the first passgate is coupled to a gate electrode of the N channel transistor of the second passgate, and wherein a gate electrode of the N channel transistor of the first passgate is coupled to a gate electrode of the P channel transistor of the second passgate.

## Patentansprüche

1. Digitale Logikschaltung, die einen Eingang und einen Ausgang aufweist und umfaßt:
einen Inverter mit einem Eingang, der an den Eingang der digitalen Logikschaltung angeschlossen ist, und einem Ausgang;
ein erstes Durchgangsgatter mit einem Dateneingang, einem Datenausgang, einem ersten Steuereingang, der an den Ausgang des Inverters angeschlossenen ist, und einem zweiten Steuereingang,der an den Eingang der digitalen Logikschaltung angeschlossen ist;
ein zweites Durchgangsgatter mit einem Dateneingang, einem Datenausgang, der an den Datenausgang des ersten Durchgangsgatters angeschlossen ist, einem ersten Steuereingang, der an den zweiten Steuereingang des ersten Durchgangsgatters angeschlossen ist, und einem zweiten Steuereingang, der an den ersten Steuereingang des ersten Durchgangsgatters angeschlossen ist; und
einen ersten bipolaren Transistor mit einem ersten Anschlußpunkt, der an den Dateneingang des zweiten Durchgangsgatters und an eine erste Versorgungsspannung angeschlossen ist, einem zweiten Anschlußpunkt, der an den Ausgang der digitalen Logikschaltung angeschlossen ist, und einem Steueranschlußpunkt, der an den Datenausgang des ersten Durchgangsgatters angeschlossen ist; und gekennzeichnet durch:
einen zweiten bipolaren Transistor mit einem ersten Anschlußpunkt, der an den Ausgang der digitalen Logikschaltung angeschlossen ist, einem zweiten Anschlußpunkt, der an den Dateneingang des ersten Durchgangsgatters und an eine zweite Versorgungsspannung angeschlossen ist, und einem Steueranschlußpunkt; und
einen P-Kanal-Transistor mit einem ersten Anschlußpunkt, der an den Ausgang der digitalen Logikschaltung angeschlossen ist, einem zweiten Anschlußpunkt, der an den Steueranschlußpunkt des zweiten bipolaren Transistors angeschlossen ist, und einem Steueranschlußpunkt, der an den Eingang der digitalen Logikschaltung angeschlossen ist.

2. Schaltung nach Anspruch 1, die einen N-Kanal-Transistor enthält, dessen erster Anschlußpunkt an den Ausgang der digitalen Logikschaltung angeschlossen ist, dessen zweiter Anschlußpunkt den Steueranschlußpunkt des zweiten bipolaren Transistors angeschlossen ist, und mit einem Steueranschlußpunkt, der an den Ausgang des Inverters angeschlossen ist.

3. Schaltung nach Anspruch 1, worin das erste Durchgangsgatter einen P-Kanal-Transistor und einen N-Kanal-Transistor umfaßt, worin das zweite Durchgangsgatter einen P-Kanal-Transistor und einen N-Kanal-Transistor umfaßt, worin eine Gateelektrode des P-Kanal-Transistors des ersten Durchgangsgatters an eine Gate-Elektrode des N-Kanal-Transistors des zweiten Durchgangsgatters angeschlossen ist, und worin eine Gate-Elektrode des N-Kanal-Transistors des ersten Durchgangsgatters an eine Gate-Elektrode des P-Kanal-Transistors des zweiten Durchgangsgatters angeschlossen ist.

## Revendications

1. Circuit logique numérique ayant une entrée et une sortie et comprenant :
un inverseur ayant une entrée couplée à l'entrée du circuit logique numérique, et une sortie ;
une première porte de passage ayant une entrée de données, une sortie de données, une première entrée de commande couplée à la sortie de l'inverseur et une deuxième entrée de commande couplée à l'entrée du circuit logique numérique ;
une deuxième porte de passage ayant une entrée de données, une sortie de données couplée à la sortie de données de la première porte de passage, une première entrée de commande couplée à la deuxième entrée de commande de la première porte de passage, et une deuxième entrée de commande couplée à la première entrée de commande de la première porte de passage ; et
un premier transistor bipolaire ayant une première borne couplée à l'entrée de données de la deuxième porte de passage et à une première tension d'alimentation, une deuxième borne couplée à la sortie du circuit logique numérique et une borne de commande couplée à la sortie de données de la première porte de passage ; et étant caractérisé par :
un deuxième transistor bipolaire ayant une première borne couplée à la sortie du circuit logique numérique, une deuxième borne couplée à l'entrée de données de la première porte de passage et à une deuxième tension d'alimentation, et une borne de commande ; et
un transistor à canal P ayant une première borne couplée à la sortie du circuit logique numérique, une deuxième borne couplée à la borne de commande du deuxième transistor bipolaire et une borne de commande couplée à l'entrée du circuit logique numérique.

2. Circuit selon la revendication 1, comprenant un transistor à canal N ayant une première borne couplée à la sortie du circuit logique numérique, une deuxième borne couplée à la borne de commande du deuxième transistor bipolaire et une borne de commande couplée à la sortie de l'inverseur.

3. Circuit selon la revendication 1, dans lequel la première porte de passage comprend un transistor à canal P et un transistor à canal N, dans lequel la deuxième porte de passage comprend un transistor à canal P et un transistor à canal N, dans lequel une électrode de grille du transistor à canal P de la première porte de passage est couplée à une électrode de grille du transistor à canal N de la deuxième porte de passage, et dans lequel une électrode de grille du transistor à canal N de la première porte de passage est couplée à une électrode de grille du transistor à canal P de la deuxième porte de passage.
